# EUROPEAN PATENT APPLICATION

(11) **EP 4 404 483 A1**
(43) Date of publication of application: **24.07.2024**
(21) Application number: 23151952.1
(22) Date of filing: 17.01.2023
(51) Int. Cl.: H04B 17/00, G01R 31/28

(54) **METHOD, CENTRAL TEST CONTROL UNIT, MEASUREMENT SYSTEM**

(71) Applicant: Rohde & Schwarz GmbH & Co. KG, 81671 München (DE)
(72) Inventor: BRAUNSTORFINGER, Thomas, 80796 München (DE); ROEGLINGER, Sebastian, 85276 Pfaffenhofen (DE); LANG, Florian, 82205 Gilching (DE); SCHMID, Björn, 81369 München (DE)
(74) Representative: Kehl, Ascherl, Liebhoff & Ettmayr Patentanwälte Partnerschaft mbB

(57) **Abstract**

The present disclosure provides a method for operating a measurement system that comprises at least one measurement application device and at least one device under test, the method comprising centrally configuring the measurement system for a test measurement, centrally verifying the correct setup of the measurement system, and performing the test measurement with the measurement system. In addition, the present disclosure provides a respective central test control unit and a respective measurement system.

## Description

### TECHNICAL FIELD

The disclosure relates to method for operating a measurement system, a respective central test control unit and a respective measurement system.

### BACKGROUND

Although applicable to any type of measurement system, the present disclosure will mainly be described in conjunction with measurement systems for wireless device development and qualification.

Development of modern electronic devices, like WIFI, UMTS/LTE, or 5G/6G enabled electronic devices with wireless communication capabilities, requires intensively testing the electronic devices during development to reliably determine the function of the electronic devices.

The complexity of modern wireless communication technologies increases the complexity of the respective test setups and the single tests that need to be performed.

Accordingly, there is a need for simplifying measurements.

### SUMMARY

The above stated problem is solved by the features of the independent claims. It is understood, that independent claims of a claim category may be formed in analogy to the dependent claims of another claim category.

Accordingly, it is provided:
A method for operating a measurement system that comprises at least one measurement application device and at least one device under test, the method comprising centrally configuring the measurement system for a test measurement, centrally verifying the correct setup of the measurement system, and performing the test measurement with the measurement system.

Further, it is provided:
A central test control unit comprising a controller configured to perform a method according to any one of the embodiments provided in the present disclosure.

Further, it is provided;
A measurement system comprising a central test control unit according to any of the embodiments provided in the present disclosure, at least one measurement application device, and at least one device under test, wherein the central test control unit is communicatively coupled to at least one of the at least one measurement application device and the at least one device under test.

The present disclosure is based on the finding that modern test requirements may require using a plurality of different measurement application devices in a measurement system and configuring a plurality of different tests in the measurement system for qualifying a device under test.

The present disclosure acknowledges that configuring such complex measurement systems is a cumbersome task.

Therefore, the present disclosure provides a method that allows easily configuring and operating a measurement system. The present disclosure further provides a respective central test control unit that may perform any embodiment of the method of the present disclosure. Further, a measurement system according to the present disclosure may comprise a respective central test control unit and any number of measurement application devices and devices under test.

In the context of the present disclosure, a measurement system may comprise any number of measurement application devices. A measurement application device in this context may comprise any device that may be used in a measurement application to acquire an input signal or to generate an output signal, or to perform additional or supporting functions in a measurement system. Such a measurement application device may comprise, for example, a signal acquisition device e.g., an oscilloscope, especially a digital oscilloscope, spectrum analyzer, or a vector network analyzer. Such a measurement application device may also comprise a signal generation device e.g., a signal generator, especially an arbitrary signal generator or a vector signal generator. Further possible measurement application devices comprise devices like calibration standards, or measurement probe tips. Of course, at least some of the possible functions, like signal acquisition and signal generation, may be combined in a single measurement application device.

In embodiments, the measurement application device may also comprise pure data acquisition devices that are capable of acquiring an input signal and provide the acquired input signal as digital input signal to a respective data storage or application server. Such pure data acquisition devices not necessarily comprise a user interface or display. Instead, such pure data acquisition devices may be controlled remotely e.g., via a respective data interface, like a network interface or a USB interface. The same applies to pure signal generation devices that may generate an output signal without comprising any user interface or configuration input elements. Instead, such signal generation devices may be operated remotely via a data connection.

The method comprises centrally configuring the measurement system for a test setup. Configuring in this context may refer to configuring single elements of the measurement system according to predefined configuration parameters. For example, a user may provide a configuration for the measurement system or at least for some of the elements of the measurement system centrally. This configuration may then be provided to or configured into the respective measurement application devices. In embodiments, specific configurations may be pre-stored and a user may select the respective configuration for configuring the measurement system.

It is understood, that in a single measurement system, multiple test setups may be configured. To this end, in embodiments, single elements of the measurement system may be configured according to a first test setup and other elements of the measurement system may be configured according to another test setup or multiple other test setups. Elements of the measurement system that may serve multiple test setups at the same time, may also be configured to serve multiple test setups concurrently. For example, a signal generator with multiple signal outputs may generate a signal for a specific test setup on each one of the signal outputs. Of course, more than two test setups may be configured in a measurement system. In a measurement system that has multiple test setups configured, the test setups may be executed or processed in parallel.

The user may be provided with a user interface that allows the user to provide configuration parameters for any of the available measurement application devices and devices under test of the measurement system.

For centrally configuring the measurement system, all or at least some of the components of the measurement system e.g., a number of measurement application devices and devices under test, may be communicatively coupled to each other and to a respective central test control unit. The expression "communicatively coupled" in this context is to be understood as comprising any type of digital or analog direct or indirect data communication capability that allows the single elements of the measurement system to exchange signals, information, or data. Such signals, information, or data may serve in the single elements to configure a respective element or to exchange measurement signals or data. A possible embodiment of the data communication may comprise implementing the SCPI, "Standard Commands for Programmable Instruments" protocol, in at least some of the elements of the measurement system. Any other protocol, publicly available, or proprietary may also be used. The data communication may be provided via wired or wireless data interfaces, while any possible types of data interfaces may be combined in a measurement system. Possible data interfaces may comprise, but are not limited to, Ethernet interfaces, WIFI interfaces, USB interfaces, or serial data interfaces.

The function of the central test control unit may in embodiments be provided in a dedicated device with a respective controller. Such a dedicated device may comprise a user interface e.g., a touchscreen and respective input devices, and may be provided locally in the measurement system. In other embodiments, the function of the central test control unit may be provided in any one of the measurement application devices. In such embodiments, the central test control unit may be provided as a hardware component with the respective function, or at least in part as a computer program product or application that comprises instructions that may be executed by a controller and cause the controller to perform the respective functions.

In a further embodiment, the function of the central test control unit may be provided as a server that is accessible over a network e.g., a local area network at the deployment site of the measurement system, or a public network, like the internet, or a combination of both. The user interaction between a user and the central test control unit may be enabled via a website or web-interface that is served by said server via the network and may be accessed with any web browser application from any adequate device, like a laptop, a computer, a tablet PC or the like.

Such a server may be a dedicated server that may be implemented as a single hardware device. The server may also be implemented as a distributed system comprising a plurality of servers, optionally with a load balancer, that distributes the load over the servers. The server may also be provided as a so-called cloud or cloud-server system that implements the server functions via virtualization methods independently of the underlying hardware.

The controller of the central test control unit or part of the controller may generally be provided as at least one of a dedicated processing element e.g., a processing unit, a microcontroller, a field programmable gate array, FPGA, a complex programmable logic device, CPLD, an application specific integrated circuit, ASIC, or the like. The controller may at least in part also be provided as a computer program product comprising computer readable instructions that may be executed by a processing element. In a further embodiment, the controller may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them.

In addition, it is understood, that any required supporting or additional hardware may be provided like e.g., a power supply circuitry and clock generation circuitry.

The method further comprises centrally verifying the correct setup of the measurement system. It is understood, that verifying may comprise comparing the intended configuration of the measurement system and the current configuration of the measurement system. Verifying may also comprise continually monitoring the measurement system for changes in the configuration.

Since the configuration of the measurement system is performed centrally, the correct setup may also be verified centrally. The "correct" setup in this context refers to the measurement system being configured as provided in the step of centrally configuring. In a laboratory environment a user may, for example, change the configuration of a measurement application device at the measurement application device locally. Such changes may be detected in the step of centrally verifying and a respective alarm may be provided or the configuration may be reverted as provided in the step of centrally configuring. In a production environment, the measurement devices may usually be locked, such that a user cannot change the configuration of the devices. If it is necessary to unlock the devices in a production environment, all user configurations may be logged or stored such that the changes performed by a user can be traced, reproduced or canceled.

Verifying the current configuration including the permanent monitoring of the configuration may comprise communicating with the single measurement application devices and devices under test and reading out the respective configurations or receiving notifications from the measurement application device and devices under test that notify about changes in the configuration. A measurement application device may, for example, notify if a configuration is modified at the measurement application device or if a cable connection is lost. The verification may be performed in the central test control unit. Alternatively, a dedicated monitoring unit may be provided as central test control unit in the measurement system. Such a dedicated monitoring unit may be another type of measurement application device.

The method further comprises the step of performing the test measurement with the centrally configured measurement system. While the test measurement is performed, generated and/or measured signals of any of the measurement application devices or any of the devices under test may be centrally displayed. This displaying of the signals may also comprise performing signal processing functions on the signals prior to displaying the signals. Of course, such signal processing functions may also be performed in the respective measurement application device or device under test prior to providing the signals for centrally displaying. Possible signal processing functions comprise arranging the signals for displaying e.g., as a two-dimensional diagram, like a time line diagram, or an eye diagram, or a three-dimensional diagram, like a waterfall diagram, or transforming a signal e.g., from the time domain into the frequency domain or vice versa.

It is understood, that the listing of the method steps does not imply any specific order. While usually the measurement system will be centrally configured prior to performing a test measurement, this is not necessarily always the case. Further, the step of centrally verifying may be performed prior, after, and while a test measurement is performed. With the step of centrally verifying, it is, for example, possible to detect cable connections coming loose while a test measurement is performed.

With the method for operating a measurement system, the central test control unit, and the measurement system of the present disclosure, it is easily possible to manage, configure and operate complex measurement systems for a user.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to the method can be combined in all variations with each other and the disclosure of the description is not limited to the claim dependencies as specified in the claim set. Further, the features of the other independent claims may be combined with any of the features of the dependent claims relating to the method in all variations, wherein respective apparatus elements may perform the respective method steps.

In an embodiment, which can be combined with all other embodiments of the method mentioned above or below, the method may further comprise detecting at least one of measurement application devices present in the measurement system and devices under test present in the measurement system. In such an embodiment, centrally configuring may comprise configuring at least one of the detected measurement application devices and the detected devices under test.

When a measurement system is configured by a user, the user may not know which measurement application devices and devices under test are available in the measurement system.

To support the user in configuring the measurement system, the available measurement application devices and devices under test may be determined automatically. A user may then be presented with a selection of the available measurement application devices and devices under test to perform the configuration of the measurement system.

Detecting the available measurement application devices and devices under test may be performed via a data connection to the devices, for example, via a network. The devices may actively be queried to respond e.g., to a broadcast message in a local network. In embodiments, at least some of the measurement application devices and devices under test may automatically register at a central database. Such a central database may be provided by the central test control unit. For detecting the devices in the measurement system, this central database may then be queried.

Of course, a user may also manually register his devices in the database and, for example, also add a location of the respective devices.

In another embodiment, which can be combined with all other embodiments of the method mentioned above or below, the method may further comprise adding at least one of a simulated measurement application device and a simulated device under test to the measurement system, wherein centrally configuring comprises configuring at least one of the simulated measurement application device and the simulated device under test. The simulated measurement application device and the simulated device under test may also be called virtual measurement application device or virtual device under test, or simply virtual devices.

A simulated measurement application device or a simulated device under test may be added to the measurement system to provide a respective simulated signal, simulate the measurement of a respective signal, or simulate the behavior of a device under test. A user may define a signal chain for the measurement system and may indicate where a simulated signal is to be inserted into the measurement system. Such a simulated signal may be provided to the respective measurement application device e.g., as a signal vector, via a data interface and the respective measurement application device may process the simulated signal as if it was acquired as usual by the measurement application device. Of course, such a measurement application device may then provide real output signals based on the simulated signal to other measurement application devices in the measurement system.

The calculations or the processing required to implement the simulated measurement application device or the simulated device under test may be performed in any one of, but are not limited to, a dedicated processing device in the measurement system, the central test control unit, any one of the measurement application devices or devices under test with free processing resources, and a respective processing element reachable over a network connection.

In a further embodiment, which can be combined with all other embodiments of the method mentioned above or below, the method may further comprise dynamically switching the measurement system between a simulated measurement application device and real measurement application device.

The measurement system may comprise simulated and real measurement application devices. For example, instead of having a signal generator create an analog signal, a signal vector may be provided via a communication interface to the measurement application device or device under test that would receive the real signal.

By dynamically switching between simulated and real measurement application devices, it is possible to compare the results of the test measurement as expected i.e., generated with known simulated signals, with the real results i.e., generated with real measurement application devices and devices under test.

Such a switch between a real and simulated measurement application device may be performed at any time before and during a test measurement. The resulting changes in the signals generated and acquired in the measurement system may then be shown to a user immediately via the user interface. The switching may be initiated by a user or automatically via a test sequence.

In a further embodiment, which can be combined with all other embodiments of the method mentioned above or below, the method may further comprise dynamically switching the measurement system between at least one of a simulated device under test, and a real device under test, and a golden device under test. The term golden device under test refers to a device under test with well known, especially ideal or correct, electrical parameters.

As with the measurement application devices, also the devices under test may be real or simulated. A simulated device under test may, for example, be provided by defining a respective signal processing function that may be applied to an input signal for the device under test to generate an output signal.

In another further embodiment, which can be combined with all other embodiments of the method mentioned above or below, at least one of centrally verifying the correct setup of the measurement system and performing the test measurement with the measurement system may comprise at least one of verifying the correct wiring of the measurement system, verifying the correct configuration of the at least one measurement application device, verifying the correct configuration of the at least one device under test, controlling the at least one measurement application device, controlling the at least one device under test, monitoring the correct operation of the at least one measurement application device, and monitoring the correct operation of the at least one device under test.

As indicated above, the step of verifying may be performed prior to performing a test measurement and while a test measurement is performed. Any detected misconfiguration or error may be reported to a user via a respective user interface.

In another embodiment, which can be combined with all other embodiments of the method mentioned above or below, centrally configuring the measurement system for a test measurement may further comprise receiving a selection of a test scenario, the test scenario comprising a list of test cases, wherein performing the test measurement may comprise performing the respective test measurements for the list of test cases.

A test scenario may be seen as a container or group of a list of test cases that are to be performed with the measurement system. Such a test scenario may refer e.g., to compliance tests according to a respective wireless communication standard, like a 3GPP communication standard.

A test scenario may comprise a plurality of test cases or at least a subset of the test cases that need to be performed to be able to qualify a device under test as conforming to the respective test requirements.

In a further embodiment, which can be combined with all other embodiments of the method mentioned above or below, centrally configuring the measurement system for a test measurement may further comprise automatically identifying test cases the measurement system can perform, and providing a user with a list of the test cases the measurement system can perform to select the test cases to be performed with the measurement system.

The measurement system may be centrally configured e.g., by a user indicating which measurement application devices and devices under test are available in the measurement system. In embodiments, the available measurement application devices and devices under test may be automatically detected.

It may, therefore, be automatically detected which test measurements or test cases may be performed or covered with the measurement system and a respective information may be provided to a user.

Especially, in combination with the selection of test scenarios by the user, the user may immediately identify possible test cases in a selected test scenario.

In another further embodiment, which can be combined with all other embodiments of the method mentioned above or below, centrally configuring the measurement system for a test measurement may further comprise identifying functions that are required for performing the test measurement but that are not present in the measurement system, and providing a user with a list of the identified functions.

In addition to identifying which test measurements are possible, it may also be identified which test measurements are not possible with the measurement system because a function may be missing. The term "function" in this context may refer to a measurement application device that is required for a test measurement not being present in the measurement system or to a single function not being present in a measurement application device, while the respective measurement application device may be available in the measurement system. Such functions may, for example, be functions that may be upgraded into the measurement application device by loading a respective application or firmware into the measurement application device.

A user may now configure a respective test measurement or select one or multiple required test measurements via a test scenario and easily identify if the required test measurement may be performed with the measurement system as currently available.

Especially, if a test scenario with multiple test cases is selected, it may be indicated to the user which of the single test cases may not be performed with the measurement system due to missing functions.

Of course, not only the test cases that may not be performed may be shown to the user. The user may also be presented with a list or missing functions, which will allow the user to decide which functions he may provide to the measurement system e.g., by integrating a respective measurement application device or upgrading a respective measurement application device.

In an embodiment, which can be combined with all other embodiments of the method mentioned above or below, providing a user with a list of the identified functions may further comprise adding at least one of the identified functions to the measurement system automatically or upon request from a user.

As explained above, single functions may be added to the measurement system by providing the respective function in a measurement application device that may already be available in the measurement system.

If this is the case, the respective function may, for example, be provided in an adequate measurement application device that is present in the measurement system automatically. Of course, adequate measurement application devices may be identified automatically by verifying if the measurement application device comprise the required resources for performing the respective function. For example, a repository of the functions i.e., the respective applications or firmware, may comprise a list of compatible measurement application devices.

Alternatively, the functions may be provided upon request by a user. It is, for example, possible that single functions are sold by the manufacturer of the measurement application devices and may be bought by the user. In such cases, a user may be provided with a pricing indication and the respective function may be installed after confirmation by the user.

In another embodiment, which can be combined with all other embodiments of the method mentioned above or below, centrally configuring the measurement system for a test measurement may further comprise receiving a definition of a test sequence comprising multiple test measurements, wherein performing the test measurement with the measurement system may further comprise performing the multiple test measurements as defined in the test sequence.

A test sequence may be manually provided by a user. A test sequency may also be provided by the above-mentioned test scenarios with multiple test cases. Each one of the test cases may refer to a respective test measurement. The test scenario may, therefore, form or be a test sequence.

A user is not required to configure the measurement system manually for every single test case of such a test scenario or test sequences. Instead, the measurement system may be centrally and automatically configured for every single test case or test measurement of the test sequence and the single test measurements of the test cases may be performed one after the other automatically.

In another further embodiment, which can be combined with all other embodiments of the method mentioned above or below, the method may further comprise dynamically determining and visualizing at least one of signal paths in the measurement system, settings of components of the measurement system, and measurement results.

In another embodiment, which can be combined with all other embodiments of the method mentioned above or below, the method may further comprise dynamically determining and visualizing at least one of a block diagram for the measurement system, especially a block diagram comprising also elements that are missing in the measurement system for the test measurement, and a wiring layout for the measurement system.

As explained above, a user may modify the configuration of the measurement system or the physical configuration of the measurement system may be automatically determined. In larger measurement system, a user will be provided with many options and possible configurations.

Dynamically determining signal paths, settings and measurement results allows centrally collecting the information that is relevant to know about the measurement system, especially for a user. The relevant information may be collected via data communication between the central test control unit and the single measurement application devices and devices under test e.g., via a protocol like the SCPI protocol.

The information that is available centrally may also be used to visualize the signal paths, configurations or settings, and measurement results of the measurement system.

When visualizing the signal paths, the single elements of the measurement system e.g., measurement application devices and devices under test, may be schematically shown to a user as block diagram, and signal paths may be indicated by respective connections or lines between the schematically shown elements. Of course, directional indicators, like arrows may also be provided to indicate directions of the respective signals.

The information about the configurations or settings of the single elements in the measurement system may in embodiments be provided when a user selects a respective element, for example points with an input device, like a touch screen or mouse pointer, onto the schematic diagram of the respective element.

Of course, the configuration of the display to the user may comprise different views or screens that may be shown on a display device, like a view for the block diagram and signal paths, and a view for the configurations or settings. In embodiments, combined views may be provided that comprise at least part of the block diagram and at least part of the configuration or setting information. Such a combined view may, for example, partition a screen into a center section for the block diagram and one or multiple side sections for the configuration and settings information.

Especially, where no cabling reconfiguration is required, a user may also configure signal paths in the visual representation e.g., the block diagram, by indicating signal flows between the single elements. For example, a virtual measurement application device may provide a measurement signal as signal vector via a network connection to another measurement application device. Such a signal connection may be provided by the user by indicating in the block diagram that the signal should be provided from the simulated measurement application device to the second measurement application device. The indication my in embodiments be provided by the user via a drag-and-drop input action. An indication of the wiring may also be provided for a required but missing wiring e.g., that is required for a specific measurement task.

As indicated above, a test scenario may be selected that comprises a plurality of test cases, each with at least one respective test measurement. In the visualization elements may be shown and marked accordingly that are missing for performing a respective test measurement. Such elements i.e., measurement application devices or devices under test, may be marked e.g., by a respective colored border, a flag or any other visual indicator.

The user may also use the visual representation to switch a measurement application device between a real device and a simulated device when needed. The same applies to switching between a simulated device under test, a real device under test and a golden device under test.

In embodiments, the visualization may also be used to show measurement results to a user. A user may, for example, select the block diagram of a respective measurement application device, and the measurement results that are acquired by the respective measurement application device may be shown to the user. Of course, the measurement results of multiple measurement application devices may also be shown to a user. In embodiments, the measurement results may be provided as windows or containers that are overlaid over the visualization and may be moved or arranged by the user as required.

In another further embodiment, which can be combined with all other embodiments of the method mentioned above or below, centrally configuring may comprise providing a user interface via a collaboration platform, and especially sharing the configuration of the measurement system via the collaboration platform, wherein a functionality to comment shared configurations is provided to a user.

The term "collaboration platform" is to be understood as any type of platform that is accessible via a network, especially the internet, and that allows multiple users to cooperate for performing given tasks. Such a collaboration platform may be a platform that is operated by the manufacturer of elements of the measurement system. Alternatively, such a collaboration platform may be any other collaboration platform that may be augmented by installing or activating specific applications in the collaboration platform.

The collaboration platform may be used to store or share configurations of the measurement system. Via such a collaboration platform, many users may share configurations for specific measurement tasks. Further, users may comment on measurement systems and their respective configurations. Further, remote support may be provided to a user via such a collaboration platform. For example, support engineers of a manufacturer of the measurement application devices may communicate with users via the collaboration platform.

It is understood, that any one of the embodiments of the method according to the present disclosure presented above or below may be performed as a computer implemented method e.g., by a processor of a central test control unit according to the present disclosure.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a flow diagram of an embodiment of a method according to the present disclosure;
Figure 2 shows a flow diagram of another embodiment of a method according to the present disclosure;
Figure 3 shows a flow diagram of a further embodiment of a method according to the present disclosure;
Figure 4 shows a flow diagram of another embodiment of a method according to the present disclosure;
Figure 5 shows a block diagram of an embodiment of a measurement system according to the present disclosure;
Figure 6 shows a block diagram of another embodiment of a measurement system according to the present disclosure;
Figure 7 shows a block diagram of an oscilloscope that may be used with an embodiment of a measurement system according to the present disclosure; and
Figure 8 shows a possible user interface for interacting with a measurement system according to the present disclosure.

In the figures like reference signs denote like elements unless stated otherwise.

### DETAILED DESCRIPTION OF THE DRAWINGS

For sake of clarity, the method-based figures will be described using the reference signs of the apparatus-based figures.

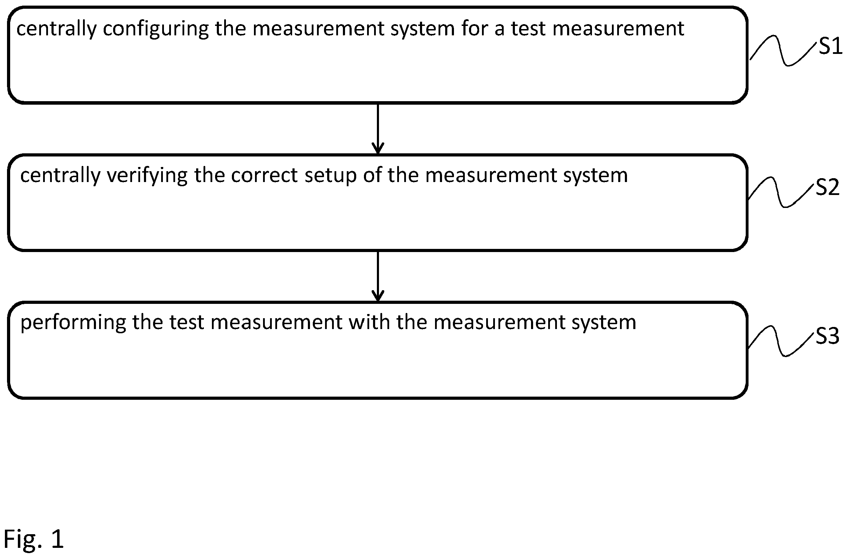

Figure 1 shows a flow diagram of a method for operating a measurement system 100, 200 that comprises at least one measurement application device 104, 204, OSC1 and at least one device under test 105, 205.

The method comprises centrally configuring S1 the measurement system 100, 200 for a test measurement, centrally verifying S2 the correct setup of the measurement system 100, 200, and performing S3 the test measurement with the measurement system 100, 200.

A user will, therefore, be provided with a simple and central solution to configure and control a complex measurement system 100, 200 that may comprise any number of measurement application devices 104, 204, OSC1 and devices under test 105, 205.

In order to complete the measurement system 100, 200, if a specific measurement application device 104, 204, OSC1 is not available, or to compare real and simulated results, the method may comprise adding at least one of a simulated measurement application device 104, 204, OSC1 and a simulated device under test 105, 205 to the measurement system 100, 200. In such an embodiment, centrally configuring S1 may further comprise configuring at least one of the simulated measurement application device 104, 204, OSC1 and the simulated device under test 105, 205.

When simulated measurement application devices 104, 204, OSC1 and devices under test 105, 205 are present in the measurement system 100, 200, the method may further comprise dynamically switching the measurement system 100, 200 between a simulated measurement application device 104, 204, OSC1 and real measurement application device 104, 204, OSC1, or dynamically switching the measurement system 100, 200 between at least one of a simulated device under test 105, 205, and a real device under test 105, 205, and a golden device under test.

Dynamically switching in this context refers to switching between the different devices at any time as indicated by a user or by a given test scenario even while a measurement is performed.

In embodiments, at least one of centrally verifying S2 the correct setup of the measurement system 100, 200 and performing S3 the test measurement with the measurement system 100, 200 may comprise verifying the correct wiring of the measurement system 100, 200, verifying the correct configuration of the at least one measurement application device 104, 204, OSC1, verifying the correct configuration of the at least one device under test 105, 205, controlling the at least one measurement application device 104, 204, OSC1, controlling the at least one device under test 105, 205, monitoring the correct operation of the at least one measurement application device 104, 204, OSC1, and monitoring the correct operation of the at least one device under test 105, 205.

The measurement application devices 104, 204, OSC1 and the devices under test 105, 205 may be capable of detecting cables being coupled to any of the input or output ports of the respective device. This allows determining, if cables are coupled to ports of the devices in the measurement system 100, 200 as expected. Ports that are correctly coupled to a cable may be qualified accordingly. For ports that are not correctly coupled to a cable a respective warning may be provided to a user.

The correct configuration of the measurement application devices 104, 204, OSC1 and the devices under test 105, 205 may be performed by reading the configuration from these devices and comparing the read configuration with an intended configuration.

Controlling and monitoring the correct operation of the measurement application devices 104, 204, OSC1 and the devices under test 105, 205 may be seen as a kind of process control or PLC controller for the measurement system 100, 200. Controlling and monitoring in this context may comprise, but is not limited to, instructing the single measurement application devices 104, 204, OSC1 and devices under test 105, 205 to perform specific functions e.g., output a specific signal, acquire a specific signal, process a specific signal, and adapt internal parameters, like an attenuation or amplification factor. The monitoring part may then verify that the instructed operation is performed correctly in the respective measurement application devices 104, 204, OSC1 and the respective devices under test 105, 205.

To further simplify the control of a measurement system 100, 200 for a user, centrally configuring S1 the measurement system 100, 200 for a test measurement may further comprise receiving a selection of a test scenario, the test scenario comprising a list of test cases. Performing S3 the test measurement may then comprise performing the respective test measurements for the list of test cases. It is understood, that every test case may refer to one or multiple test measurements. A test scenario may be thought of a compilation of single tests that are to be performed. Such test scenarios may, for example, be used to perform compliance tests for electrical devices.

Centrally configuring S1 the measurement system 100, 200 for a test measurement may further comprise receiving a definition of a test sequence comprising multiple test measurements. Performing S3 the test measurement with the measurement system 100, 200 may further comprise performing the multiple test measurements as defined in the test sequence.

The term test sequency refers to any type of sequence of test measurements that are to be performed. In contrast, a test scenario is a specific selection of test cases with respective test measurements that form part of a well-defined group of test measurements, for example of a group of test measurements required during a compliance test. Such a test scenario may, therefore, be seen as special implementation of a test sequence.

To allow a user to interactively control the measurement system 100, 200, the method may further comprise dynamically determining and visualizing at least one of signal paths in the measurement system 100, 200, settings of components of the measurement system 100, 200, and measurement results.

The visualization may also comprise a block diagram for the measurement system 100, 200, especially comprising also elements that are missing in the measurement system 100, 200 for specific intended test measurements, and a wiring layout for the measurement system 100, 200.

As explained above, the visualization may be provided based on schematic block diagrams that represent the measurement application devices 104, 204, OSC1 and the devices under test 105, 205. The visualization may also comprise block diagrams for elements that are missing in the measurement system 100, 200 for specific intended test measurements. These elements may be marked respectively.

In order to provide easy access to a user interface for performing the method of figure 1, centrally configuring S1 may comprise providing a user interface via a collaboration platform, and sharing the configuration of the measurement system 100, 200 via the collaboration platform, wherein a functionality to comment shared measurement systems 100, 200 may also be provided to a user. A chat with support staff may also be provided.

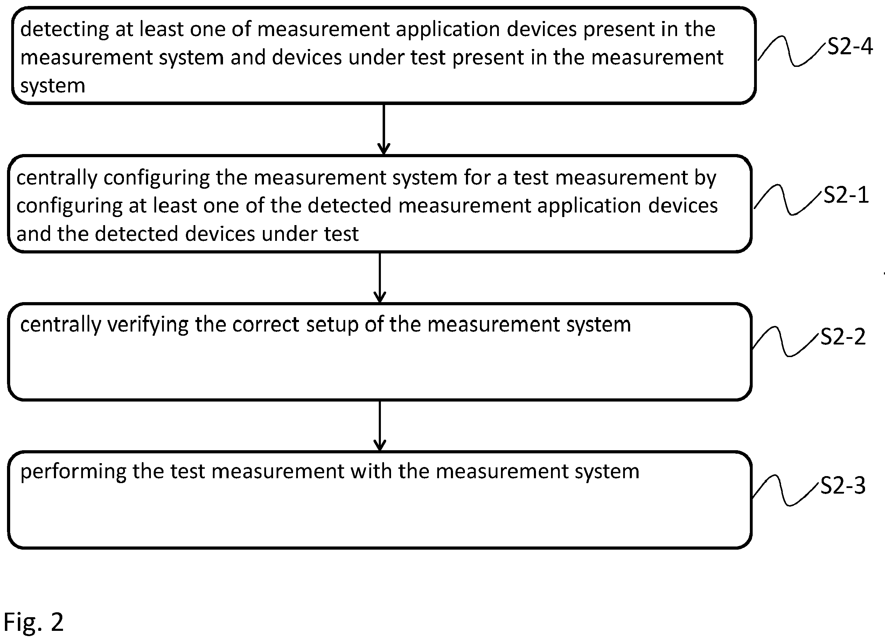

Figure 2 shows a flow diagram of another method for operating a measurement system 100, 200. The method of figure 2 is based on the method of figure 1, and comprises centrally configuring S2-1 the measurement system 100, 200 for a test measurement, centrally verifying S2-2 the correct setup of the measurement system 100, 200, and performing S2-3 the test measurement with the measurement system 100, 200.

The method of figure 2 further comprises detecting S2-4 at least one of measurement application devices 104, 204, OSC1 present in the measurement system 100, 200 and devices under test 105, 205 present in the measurement system 100, 200. As explained above, the measurement application devices 104, 204, OSC1 present in the measurement system 100, 200 and devices under test 105, 205 present in the measurement system 100, 200 may, for example, be detected by querying devices in a network. Centrally configuring S2-1 in this embodiment may comprise configuring at least one of the detected measurement application devices 104, 204, OSC1 and the detected devices under test 105, 205.

With this embodiment, the user is not required to manually define all available devices for a measurement setup, instead the available devices will be identified automatically. Of course, manual input by a user may also be possible.

In addition, when detecting the devices that are available in the measurement system 100, 200, the functions or capabilities of the single devices may be determined. Modern measurement application devices 104, 204, OSC1 may offer the possibility to augment the functionality of the respective device by installing respective applications, which in cases need to be bought. Therefore, even if a specific hardware is detected to be present in the measurement system 100, 200, this does not necessarily provide complete information about the functionality that is provided by the hardware. With the step of detecting the functions and capabilities of the single devices, a detailed functional analysis or determination for the measurement system 100, 200 is possible.

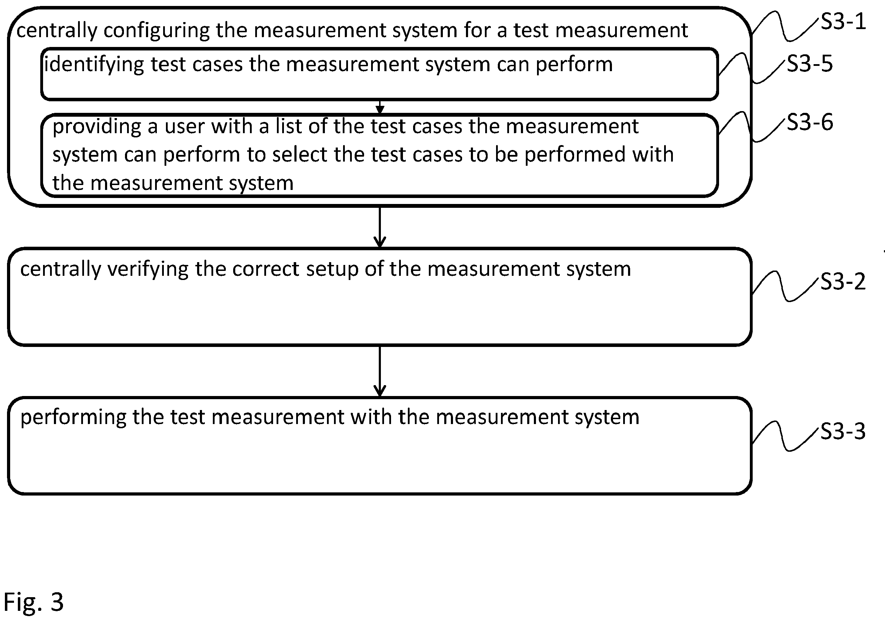

Figure 3 shows a flow diagram of a further method for operating a measurement system 100, 200. The method of figure 3 is based on the method of figure 1, and comprises centrally configuring S3-1 the measurement system 100, 200 for a test measurement, centrally verifying S3-2 the correct setup of the measurement system 100, 200, and performing S3-3 the test measurement with the measurement system 100, 200.

In the method of figure 3 the step of centrally configuring S3-1 the measurement system 100, 200 for a test measurement further comprises identifying S3-5 test cases with respective test measurements or single test measurements of a test sequence the measurement system 100, 200 can perform, and providing S3-6 a user with a list of the test cases or test measurements the measurement system 100, 200 can perform to select the test cases to be performed with the measurement system 100, 200.

With these additional steps, a user may immediately identify any test cases and test measurements that he may or may not perform with the measurement system 100, 200. Of course, these steps may be combined with the additional step of figure 2. In such an embodiment, the capabilities of the measurement system 100, 200 will be automatically determined and all possible test cases may be presented to the user automatically.

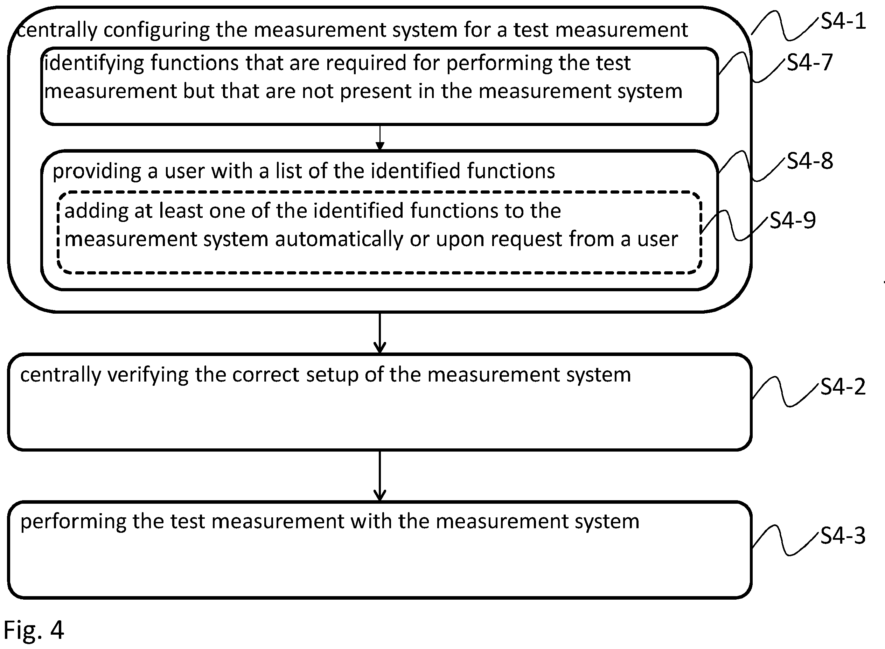

Figure 4 shows a flow diagram of another method for operating a measurement system 100, 200. The method of figure 4 is based on the method of figure 1, and comprises centrally configuring S4-1 the measurement system 100, 200 for a test measurement, centrally verifying S4-2 the correct setup of the measurement system 100, 200, and performing S4-3 the test measurement with the measurement system 100, 200.

In the method of figure 4 centrally configuring S4-1 the measurement system 100, 200 for a test measurement further comprises identifying S4-7 functions that are required for performing the test measurement but that are not present in the measurement system 100, 200, and providing S4-8 a user with a list of the identified functions. With the list being provided to the user the method may also comprise adding S4-9 at least one of the identified functions to the measurement system 100, 200 automatically or upon request from a user. If identified functions are provided to the measurement system 100, 200 automatically, the list not necessarily is shown to a user. Functions may for example be added automatically, if acquiring the function is possible via installing an application in a respective device, and of the application is free of charge. Although the term "list" is used, it is understood that any adequate form of displaying may be used.

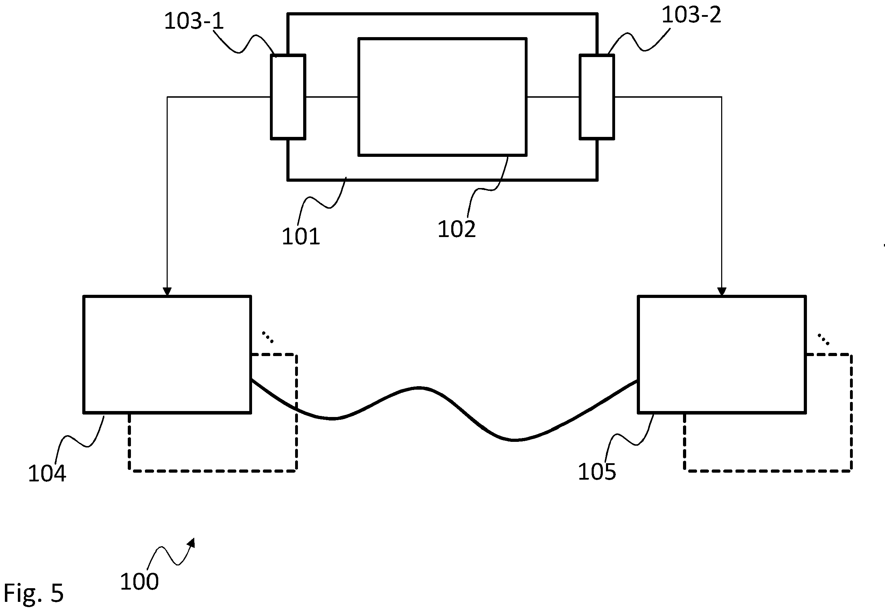

Figure 5 shows a block diagram of a measurement system 100. The measurement system 100 comprises a central test control unit 101 with a controller 102, and two communication interfaces 103-1, 103-2. The communication interface 103-1 is coupled to a measurement application device 104, wherein more measurement application devices are hinted at by a dashed box. The communication interface 103-2 is coupled to a device under test 105, wherein more devices under test are hinted at by a dashed box. The central test controller 102 is, therefore, communicatively coupled to the measurement application device 104 and the device under test 105. A single communication interface is also possible.

It is understood, that the communication interfaces 103-1, 103-2 may comprise any kind of wired and wireless communication interfaces, like for example a network communication interface, especially an Ethernet, wireless LAN or WIFI interface, a USB interface, a Bluetooth interface, an NFC interface, a visible or non-visible light-based interface, especially an infrared interface.

The central test control unit 101 is shown as a dedicated device in the measurement system 100, and the controller 102 serves to implement any one of the embodiments of the method according to the present disclosure. The method may, therefore, be implemented as a computer-implemented method in the controller 102. To this end, the controller 102 may be provided with computer-readable instructions, that when executed by the controller 102 cause the controller to perform the method.

As a dedicate device, the central test control unit 101 may, for example, be provided as a computer or PC that executes a respective application. This computer may directly be user by a user to interface or interact with the application.

In other embodiments, such a computer or PC may execute, for example, a Linux-based server operating system, and serve a user interface for operating the measurement system 100 as web-based application. Such a web-based application may be used by any user by opening the respective web-based application via a web browser from his own device e.g., an office PC, Laptop, or tablet PC.

In other embodiments, the functionality of the central test control unit 101 may be implemented in any one of the measurement application devices 104, or even the devices under test 105. In such an embodiment, the functionality of the central test control unit 101 may be implemented as an application that may be installed in the respective device and may be executed in addition to the standard functionality of the respective device. A user may interact with the central test control unit 101 via a user interface of the measurement application device 104 or via a network interface, like a web-based interface.

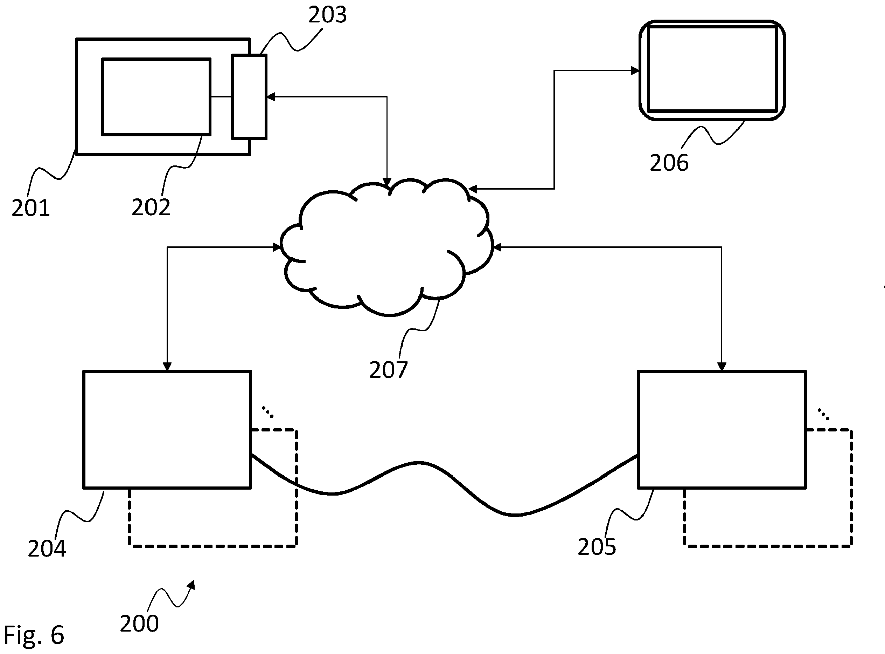

Figure 6 shows a block diagram of another measurement system 200. The measurement system 200 is based on the measurement system 100. The measurement system 200, therefore, comprises a central test control unit 201 with a controller 202, and a communication interface 203. The communication interface 203 is coupled to a network 207. The explanations regarding the measurement system 100 apply mutatis mutandis to the measurement system 200.

Further, a measurement application device 204 is coupled to the network 207, wherein more measurement application devices are hinted at by a dashed box. In addition, a device under test 205 is coupled to the network 207, wherein more devices under test are hinted at by a dashed box.

The network 207 may be provided as a local network e.g., on the premises of the user of the measurement system 200. The network 207 may at least in part also comprise a public network, like the internet. Such a network may comprise any type of network devices, like switches, hubs, routers, firewalls, and different types of network technologies.

The measurement system 200 further comprises a user device 206, which is schematically shown as a tablet PC. It is understood, that the user device 206 may also be provided as any other capable or adequate device.

In the measurement system 200, the central test control unit 201 is provided as a server that may be located remotely to the measurement application devices 204, the devices under test 205, and the user device 206. Such a server may comprise a dedicated hardware. Alternatively, such a server may also comprise a virtualized server or a cloud server.

It is understood, that with this arrangement, the central test control unit 201 may be provided remotely from the measurement application devices 204, the devices under test 205, and the user device 206. The same applies to the user device 206. In embodiments, multiple user devices 206 may be present in the measurement system 200.

The functionality of the central test control unit 201 may be implemented in the backend of the server, while any user interaction may be performed via a web-based frontend and the user device 206.

The central test control unit 201 may also provide an application that may be integrated by users of a collaborative platform that allows teams of users to cooperate in performing tasks together via the collaborative platform.

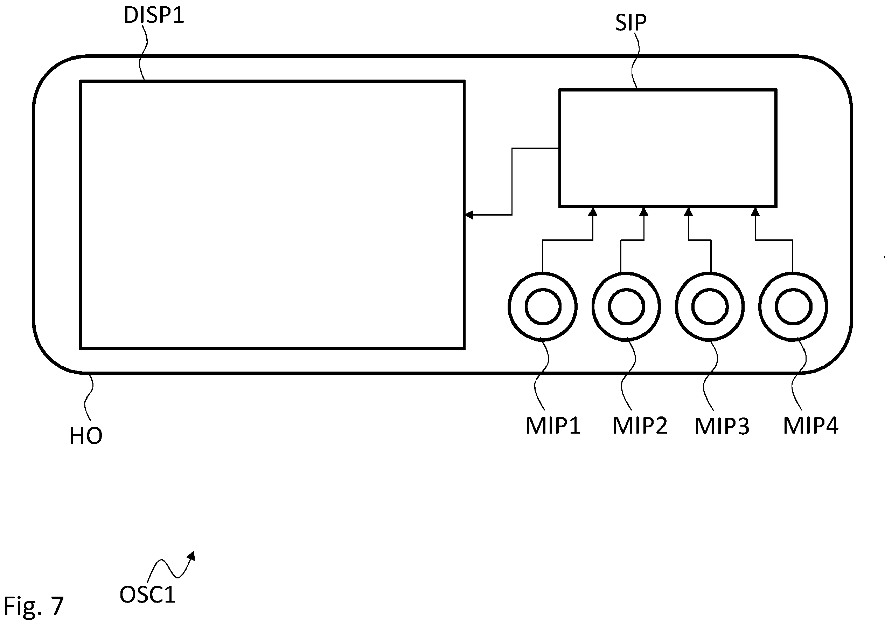

Figure 7 shows a block diagram of an oscilloscope OSC1 that may be used as an embodiment of a measurement application device for a measurement system according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user.

The signal processor SIP may serve in an embodiment to implement the functionality of the central test control unit according to any one of the embodiments provided herein in addition to the original functionality of the oscilloscope OSC1. In such embodiments, the user may interact with the central test control unit via the display DISP1, which may comprise a touch screen, or other input elements of the oscilloscope OSC1, or via a network-based, especially web-based, interface.

Although not explicitly shown, it is understood, that the oscilloscope OSC1 may also comprise signal outputs that may be used to generate test signals or calibration signals. Such calibration signals allow calibrating the measurement system prior to performing any measurement. The process of calibrating and correcting any measurement signals based on the calibration may also be called de-embedding and may comprise applying respective algorithms on the measured signals.

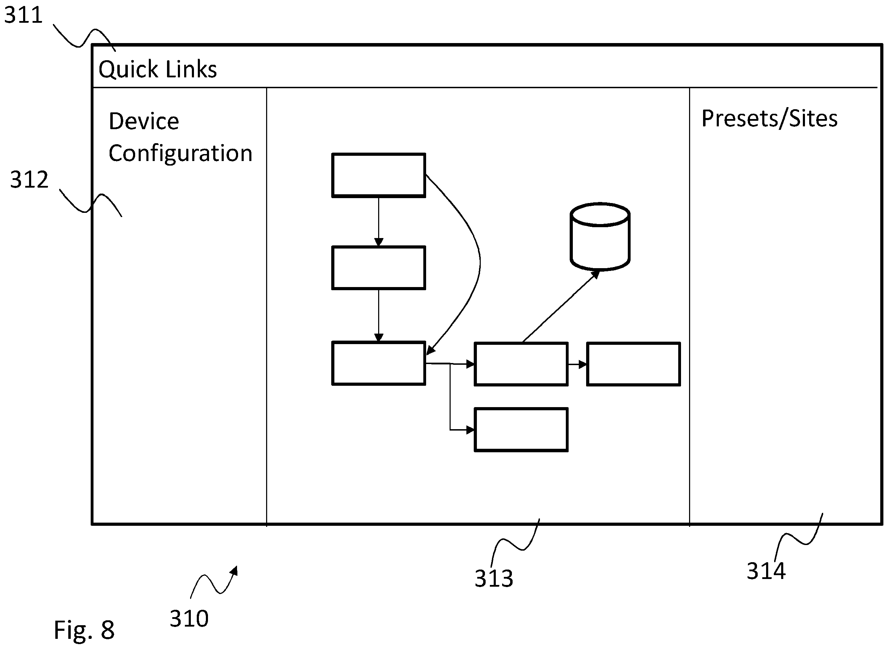

Figure 8 shows a possible user interface 310 for interacting with a measurement system 100, 200 according to the present disclosure.

The user interface 310 has four main sections, on the top from one side to the other a quick function links section 311 or bar is provided. Below the quick function links section 311, the user interface 310 is divided into three columns, the left column showing a device configuration section 312, the center column showing a block diagram and dataflow section 313, the right column showing a presets and sites section 314. Of course, the shown embodiment is merely an exemplary embodiment. In embodiments, the single sections may be at least one of collapsible, resizable, movable, and removable. In embodiments, a user may add sections to the user interface 310 as desired.

The quick function links section 311 serves for a user to quickly access functions of the measurement system. To this end, the quick function links section 311 may comprise links in the form of at least one of buttons, icons, and text. If a user interacts with such a link, the respective function may be executed. For example, a new section or an overlay section over the sections of the user interface 310 may be opened, that section showing the content relevant for the link to the user.

The device configuration section 312 may show the configuration of devices in the user interface 310, especially of devices that the user selects in the block diagram and dataflow section 313. The configuration may be shown to the user and a user may interact with e.g., modify, the configuration of the respective device in the device configuration section 312. Of course, the user may also be provided with other means for modifying the configuration of a device e.g., via a pop-up that opens if a user interacts with a respective device in the block diagram and dataflow section 313.

The device configuration section 312 may automatically collapse e.g., to the left, if a user does not interact with the device configuration section 312 for a specified time. The device configuration section 312, if automatically collapsible, may also provide the user with means to pin down the device configuration section 312 i.e., prevent the automatic collapsing of the device configuration section 312.

The block diagram and dataflow section 313 may comprise a block diagram of the measurement system as configured by the user. It is understood, that the block diagram in the block diagram and dataflow section 313 not necessarily shows all devices that are available in the measurement system. Instead, the block diagram may show only those devices that a user added for a test measurement or measurement task to the configuration of the measurement system.

In the block diagram, not only the devices may be shown, but also signal flows e.g., indicated by arrows that connect the single devices.

Although not shown in the user interface 310, the arrows may comprise differently shaped, colored, or patterned lines or arrow heads or text may be added to the arrows, to indicated the type of signal that the arrow refers to.

Further, different devices may be indicated by different shapes, while square boxes may refer to measurement application devices that may acquire or generate signals, round cylinder shapes may refer to measurement application devices that comprise data storage devices. It is understood, that other types of devices are also possible, for example, switches or switch matrixes. A user may control such switches or switch matrixes via the block diagram and dataflow section 313.

Further, for each one of the devices, an indication may be given that indicates if the respective device is a real or a simulated device. The user may be provided with means to switch between a real and a simulated device, if both are present, e.g., via the block diagram and dataflow section 313.

The presets and sites section 314 may comprise a list of different presets or measurement sites. By selecting one of the presets or measurement sites, a user may e.g., switch the content of the device configuration section 312 and block diagram and dataflow section 313 to display the data that is relevant for the respective preset or site. In this regard, the term preset may refer to a predefined or stored configuration of the respective measurement system. The term site may refer to a physically different setup i.e., a different measurement system, with different devices.

With the user interface 310 a guided user experience may be implemented by consecutively providing different pre-determined information and input possibilities to a user. Such a guided user experience may, for example, comprise a screen that indicates to a user which devices are available in a measurement system, and if any updates or additional applications are available for the respective devices. Such a screen may be optional or not included in a multi-step user experience, since it may be accessed independently of a specific measurement task.

The next step of such a user experience may present the user with a selection of use cases or devices under test, which will allow determining the exact test measurements that are to be performed. Such a screen may, for example, provide the user with a list of possible devices under test and a list of respective test cases for the single devices under test. For example, for a transmitter the possible test cases may exemplarily indicate 5G, 6G, WIFI test cases. For a receiver the test cases may exemplarily indicate 5G, 6G, Radar, Radar Simulation. The possible test cases may be shown as subordinate to the respective device under test or in a dedicated screen after the device under test is selected by a user.

It is understood, that the list of devices under test and possible test cases may be dynamically created based on the measurement application devices and the devices under test detected in the measurement system.

After a user selects a test, the configuration for the respective test case may be automatically loaded for the measurement system. In this regard, the configuration may refer to the configurations of the single measurement application devices, the devices under test and the signal flows as required for performing the relevant test measurements.

While test measurements are performed, measurement results may also be shown to the user on the user interface 310 e.g., as overlay.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### LIST OF REFERENCE SIGNS

- S1, S2, S3, S2-1, S2-2, S2-3, S2-4: method step
- S3-1, S3-2, S3-3, S3-5, S3-6: method step
- S4-1, S4-2, S4-3, S4-7, S4-8, S4-9: method step

- 100, 200: measurement system
- 101, 201: central test control unit
- 102, 202: controller
- 103-1, 103-2, 203: communication interface
- 104, 204: measurement application device
- 105, 205: device under test

- 206: user device
- 207: network

- 310: user interface
- 311: quick function links section
- 312: device configuration section
- 313: block diagram and dataflow section
- 314: presets and sites section

- OSC1: oscilloscope
- HO: housing
- MIP1, MIP2, MIP3, MIP4: measurement input
- SIP: signal processing
- DISP1: display

## Claims

1. Method for operating a measurement system (100, 200) that comprises at least one measurement application device (104, 204, OSC1) and at least one device under test (105, 205), the method comprising:
centrally configuring (S1, S2-1, S3-1, S4-1) the measurement system (100, 200) for a test measurement;
centrally verifying (S2, S2-2, S3-2, S4-2) the correct setup of the measurement system (100, 200); and
performing (S3, S2-3, S3-3, S4-3) the test measurement with the measurement system (100, 200).

2. Method according to claim 1, further comprising detecting (S2-4) at least one of measurement application devices (104, 204, OSC1) present in the measurement system (100, 200) and devices under test (105, 205) present in the measurement system (100, 200);
wherein centrally configuring (S1, S2-1, S3-1, S4-1) comprises configuring at least one of the detected measurement application devices (104, 204, OSC1) and the detected devices under test (105, 205).

3. Method according to any one of the preceding claims, further comprising adding at least one of a simulated measurement application device (104, 204, OSC1) and a simulated device under test (105, 205) to the measurement system (100, 200);
wherein centrally configuring (S1, S2-1, S3-1, S4-1) further comprises configuring at least one of the simulated measurement application device (104, 204, OSC1) and the simulated device under test (105, 205).

4. Method according to claim 3, further comprising at least one of:
dynamically switching the measurement system (100, 200) between a simulated measurement application device (104, 204, OSC1) and a real measurement application device (104, 204, OSC1); and
dynamically switching the measurement system (100, 200) between at least one of a simulated device under test (105, 205), and a real device under test (105, 205), and a golden device under test.

5. Method according to any one of the preceding claims, wherein at least one of centrally verifying (S2, S2-2, S3-2, S4-2) the correct setup of the measurement system (100, 200) and performing (S3, S2-3, S3-3, S4-3) the test measurement with the measurement system (100, 200) comprises at least one of:
verifying the correct wiring of the measurement system (100, 200);
verifying the correct configuration of the at least one measurement application device (104, 204, OSC1);
verifying the correct configuration of the at least one device under test (105, 205);
controlling the at least one measurement application device (104, 204, OSC1);
controlling the at least one device under test (105, 205);
monitoring the correct operation of the at least one measurement application device (104, 204, OSC1); and
monitoring the correct operation of the at least one device under test (105, 205).

6. Method according to any one of the preceding claims, wherein centrally configuring (S1, S2-1, S3-1, S4-1) the measurement system (100, 200) for a test measurement further comprises receiving a selection of a test scenario, the test scenario comprising a list of test cases; and
wherein performing (S3, S2-3, S3-3, S4-3) the test measurement comprises performing respective test measurements for the list of test cases.

7. Method according to any one of the preceding claims, wherein centrally configuring (S1, S2-1, S3-1, S4-1) the measurement system (100, 200) for a test measurement further comprises identifying (S3-5) test cases the measurement system (100, 200) can perform; and
providing (S3-6) a user with a list of the test cases the measurement system (100, 200) can perform to select the test cases to be performed with the measurement system (100, 200).

8. Method according to any one of the preceding claims, wherein centrally configuring (S1, S2-1, S3-1, S4-1) the measurement system (100, 200) for a test measurement further comprises:
identifying (S4-7) functions that are required for performing the test measurement but that are not present in the measurement system (100, 200); and
providing (S4-8) a user with a list of the identified functions.

9. Method according to preceding claim 8, wherein providing a user with a list of the identified components further comprises:
adding (S4-9) at least one of the identified functions to the measurement system (100, 200) automatically or upon request from a user.

10. Method according to any one of the preceding claims, wherein centrally configuring (S1, S2-1, S3-1, S4-1) the measurement system (100, 200) for a test measurement further comprises receiving a definition of a test sequence comprising multiple test measurements; and
wherein performing (S3, S2-3, S3-3, S4-3) the test measurement with the measurement system (100, 200) further comprises performing the multiple test measurements as defined in the test sequence.

11. Method according to any one of the preceding claims, further comprising dynamically determining and visualizing at least one of:
signal paths in the measurement system (100, 200);
settings of components of the measurement system (100, 200); and
measurement results.

12. Method according to any one of the preceding claims, further comprising dynamically determining and visualizing at least one of:
a block diagram for the measurement system (100, 200), especially a block diagram comprising also elements that are missing in the measurement system (100, 200) for the test measurement; and
a wiring layout for the measurement system (100, 200).

13. Method according to any one of the preceding claims, wherein centrally configuring (S1, S2-1, S3-1, S4-1) comprises:
providing a user interface via a collaboration platform; and
especially sharing the configuration of the measurement system (100, 200) via the collaboration platform, wherein a functionality to comment shared configurations is provided to a user.

14. Central test control unit (101, 201) comprising:
a controller (102, 202) configured to perform a method according to any one of the preceding claims 1 - 13.

15. Measurement system (100, 200) comprising:
a central test control unit (101, 201) according to claim 14;
at least one measurement application device (104, 204, OSC1); and
at least one device under test (105, 205);
wherein the central test control unit (100, 200) is communicatively coupled to at least one of the at least one measurement application device (104, 204, OSC1) and the at least one device under test (105, 205).
